(19) Europäisches Patentamt
European Patent Office
Office européen des brevets

(11) **EP 2 299 642 A2**

(12) **EUROPEAN PATENT APPLICATION**

(43) Date of publication:
    **23.03.2011 Bulletin 2011/12**

(51) Int Cl.:
    ***H04L 27/34*** (2006.01)

(21) Application number: **10175182.4**

(22) Date of filing: **03.09.2010**

(84) Designated Contracting States:
    **AL AT BE BG CH CY CZ DE DK EE ES FI FR GB GR HR HU IE IS IT LI LT LU LV MC MK MT NL NO PL PT RO SE SI SK SM TR**
    Designated Extension States:
    **BA ME RS**

(30) Priority: **14.09.2009  CN 200910173754**

(71) Applicant: **Siemens Aktiengesellschaft**
    **80333 München (DE)**

(72) Inventors:
    • **Deng, Xiao Dong**
      **100102 Beijing Chaoyang District (CN)**
    • **Horst, Dieter**
      **90556, Cadolzburg (DE)**
    • **Yu, Dan**
      **100102, Beijing (CN)**
    • **Yuan, Yong**
      **102208, Beijing (CN)**

(54) **A method meeting the spectral mask in a radiofrequency identification system and a device therefor**

(57)    The present invention provides a method meeting the spectral mask in a radiofrequency identification system, wherein said radiofrequency identification system includes a reader/writer and a set of tags, and the method includes the following steps: (1) in the forward stage of said radiofrequency identification system, said reader/writer first performs single sideband modulation of the signals to be sent, shifts the frequency of said modulated signals, and then sends said signals resulting from the frequency shifting; (2) in the reverse stage of said radiofrequency identification system, said reader/writer sends only one carrier wave to said tags. The method of the present invention enables reader/writers to use high-data-transfer-rate forward link to communicate, without the fear of failing to meet ETSI spectral mask requirements.

FIG 7

**Description**

Technical Field

The present invention relates to Radiofrequency Identification (shorted to RFID) technology, and more particularly to a method meeting the spectral mask in a radiofrequency identification system and a device therefor.

Background Technology

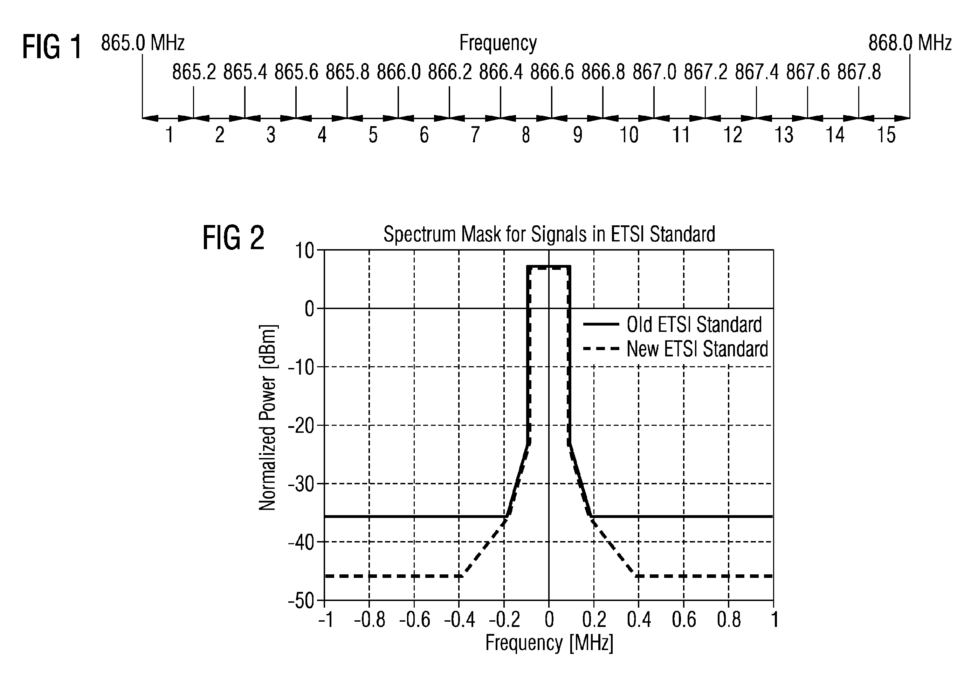

In generation 2 of Class 1 Ultra High Frequency (UHF) Radiofrequency Identification (RFID) Protocol of EPCglobal (see EPCglobal Standard and the same follows hereafter), a reader/writer sends information to one or more tags by using Double Sideband Amplitude Shift Keying (DSB-ASK), Single Sideband Amplitude Shift Keying (SSB-ASK) or Phase Reversal Amplitude Shift Keying (PR-ASK) to modulate the radiofrequency carrier. In addition to sending signals, the radiofrequency identification reader/writer performs the authentication operation, so that the EPCglobal Standard meets the local requirements on stray radiofrequency radiation out of communication channel and out of band. The European Telecommunications Standards Institute (ETSI) has proposed in EN 302 208 [1] [2] that 15 communication channels be allocated between 865 MHz to 868 MHz frequency band, with each level of power reaching 2 W and the width of each communication channel being 200KHz, thus meeting the needs of a Radiofrequency Identification (RFID) device. For the communication channels defined in the ETSI standard, see Figure 1.

In addition, the definition of spectral mask is also included in EN 302 208, which sets the limitations for all modulation signals, including all sidebands related to the carrier waves above the allowed stray level. The new and old spectral masks defined for the signals in the ETSI standard are shown in Figure 2. The broken line represents the spectral masks defined in the old ETSI standard, and the solid line represents the spectral masks defined in the new ETSI standard. The old ETSI spectral masks specify that the power of carrier waves outside $\pm 200$ KHz from the main carrier should not exceed -36 dBm, and compared to the old spectral masks, the new ETSI spectral masks set forth more requirements, and require that the power of carrier waves outside $\pm 400$ KHz from the main carrier should not exceed -46 dBm.

There are certain difficulties in modulating signals to meet the requirements of the ETSI spectral masks, especially when the reader/writer communicates at a high data transfer rate in the forward link. The signals in the base band are usually used to modulate a carrier wave at a higher frequency to generate the modulation signal. When using the double sideband modulation method, there is a key result, that is, the range of the signal frequency will be doubled, yet the shape of the frequency spectrum has little change. Therefore, the frequency spectrum of the base band signal can be used to describe whether the modulation signal meets the requirements of the ETSI spectral mask.

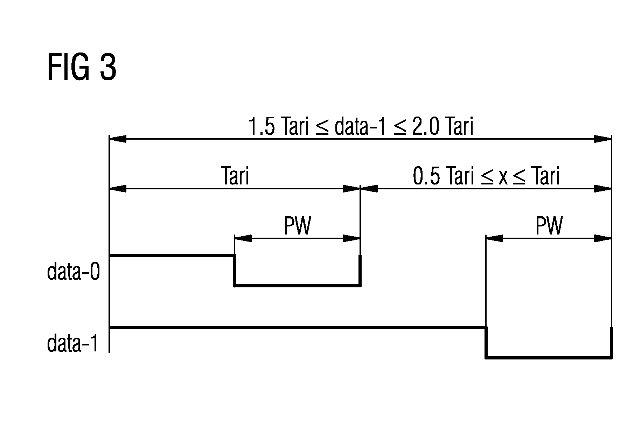

According to the ETSI requirements, the base band of the forward link encodes the signals using Pulse Interval Encoding (PIE), which is shown in Figure 3. In this case, the high level represents the transferred continuous wave (CW); the low level represents damped continuous wave. "Tari" is the reference time interval for sending signals from the reader/writer to tags and is also the duration of each "data-0". "x" represents the extra duration that each "data-1" has than "data-0". After the Continuous Fourier Transform (CFT), the frequency spectrum of the base band signal includes the frequency spectrum of "data-0" and "data-1" as its component part because the base band signal of the forward link is a sequence of "data-0" and "data-1". Table 1 lists the distribution of the peaks of the base band signal frequency spectrum when "Tari" and "x" are set to different values. As mentioned in the above, the width of a communication channel is 200KHz. The second peak appears in the communication channel when (Tari, x) is set to ($25\mu$s, $25\mu$s) and ($12.5\mu$s, $12.5\mu$s). However, the first peak appears outside the communication channel when (Tari, x) is set to ($6.25\mu$s, $3.125\mu$s).

Table 1: Distribution of Peaks of Baseband Signal Frequency Spectrum

| (Tari, x) ($\mu$s) | (25, 25) | (12.5, 12.5) | (6.25, 3.125) |
|---|---|---|---|
| First peak (KHz) | 20 | 40 | 106 |
| Second peak (KHz) | 40 | 80 | 160 |

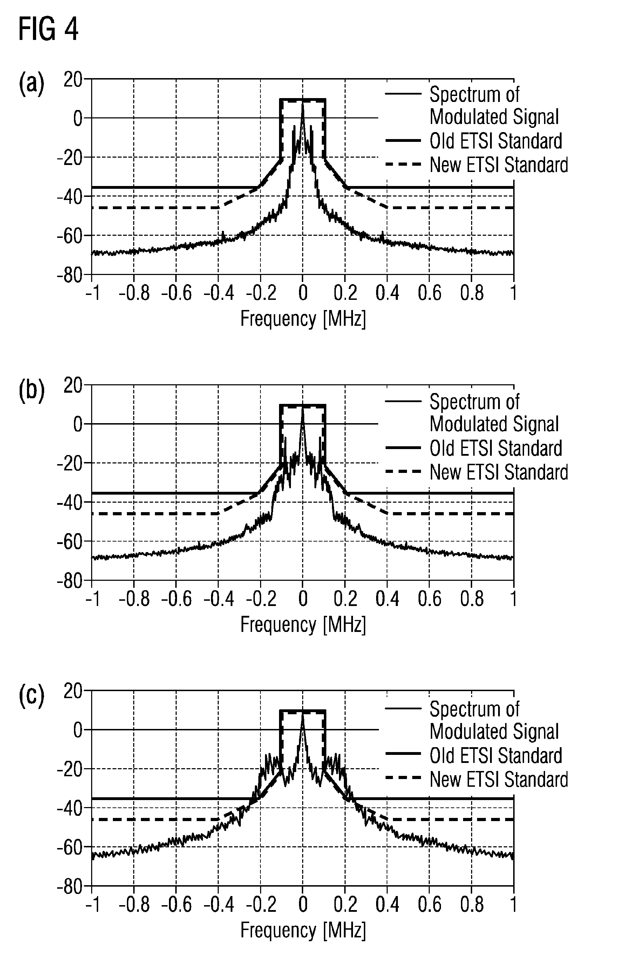

In addition, the frequency spectrum of the modulation signal shown in Figure 4 is captured after the radiofrequency output of the reader/writer is connected to the frequency spectrum analyzer via a 50$\Omega$ connector. As shown in Figure 4, when "Tari" is set to $25\mu$s, "x" is set to one "Tari", the frequency spectrum of the modulation signal is fully enclosed by the spectral mask, and the security allowance is quite large. When "Tari" is set to $12.5\mu$s, "x" is set to one "Tari", the frequency spectrum of the modulation signal is just enclosed by the spectral mask, and the security allowance is already very small. When "Tari" is set to $6.25\mu$s, "x" is set to one half "Tari", the peak of the modulation signal frequency spectrum already exceeds the spectral mask, and there is no space under the spectral mask for transfer of the frequency spectrum. In general, the peak distribution of the base band signal and the frequency spectrum capture of the modulation signal indicate that when "Tari" is set to $6.25\mu s$, the transfer frequency spectrum of the DSB signal has already exceeded the ETSI spectral mask. If the reader/writer chooses not to communicate at a high data transfer rate, the frequency spectrum of the modulation signal can meet the requirements of the ETSI spectral mask. If "Tari" is set to $12.5\mu s$, and "x" is set to one "Tari", the reader/writer is not allowed to communicate. In other words, the reader/writer sacrifices performance in order to meet the needs of the ETSI spectral mask. With "Tari" set to $6.25\mu s$, if "Tari" is set to $12.5\mu s$, then nearly half of the time interval of the forward link is occupied; whereas a quarter of that is occupied if "Tari" is set to $25\ \mu s$.

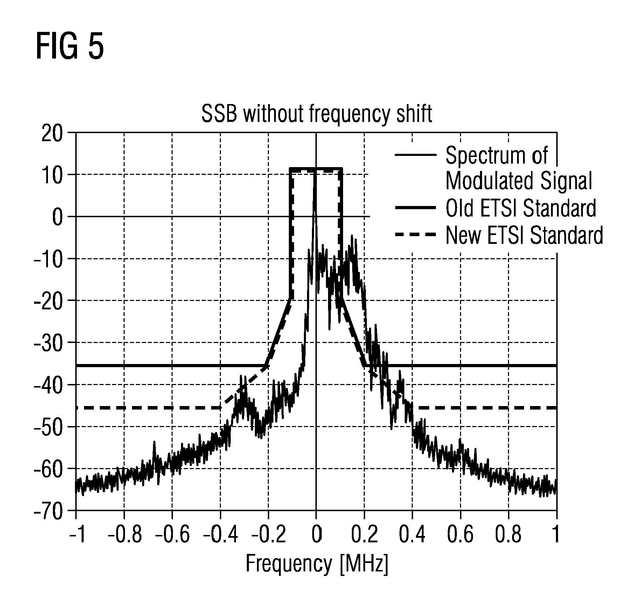

In general, if the reader/writer communicates using single sideband (SSB) modulation rather than double sideband (DSB) modulation, the frequency spectrum of the modulation signal may meet the requirements of the spectral mask because the bandwidth of the single sideband signal is half that of the double sideband signal. The comparison between the frequency spectrum of the modulation signal modulated by the upper single sideband and the ETSI spectral mask is shown in Figure 5. "Tari" is set to $6.25\mu s$, and "x" is set to one half "Tari". As is shown in Figure 5, if the upper single sideband modulation is used, the performance within the low frequency range can be greatly improved. However, the frequency spectrum of the upper single sideband modulation signal cannot meet the requirements of the ETSI spectral mask, because there is little improvement within the high frequency range. There are similar problems when the tags are read and written through the lower single sideband modulation.

The objective of the present invention is to provide a method meeting the spectral mask in a radiofrequency identification system and a system meeting the spectral mask in a radiofrequency identification system, so as to meet the requirements of the ETSI defined spectral masks when data is transferred at a high rate in the forward link of the radiofrequency identification system.

To achieve this objective, the present invention provides a method meeting the spectral mask in a radiofrequency identification system, wherein said radiofrequency identification system includes a reader/writer and a set of tags, and the method includes the following steps:

(1) in the forward stage of said radiofrequency identification system, said reader/writer first performs single sideband modulation of the signals to be sent, shifts the frequency of said modulated signals, and then sends said signals from the frequency shifting;

(2) in the reverse stage of said radiofrequency identification system, said reader/writer sends only one carrier wave to said tags.

Preferably, in said step (2), in the reverse stage of said radiofrequency identification system, said reader/writer removes said frequency shift and sends one carrier wave to said tags at the original carrier frequency only.

Preferably, in said step (1), said reader/writer first performs single sideband modulation of the signals to be sent, shifts the frequency of said modulated signals, and then sends said signals from the frequency shifting, wherein said step further includes:

said reader/writer performs baseband coding and pulse shaping of the signals to be sent;
said reader/writer delays and filters the shaped signals to generate two branch signals I, Q;
said reader/writer performs phase rotation of said two branch signals I, Q;
said reader/writer converts the signals resulting from the phase rotation to analog signals and sends through the RF modulation.

Preferably, said filter is a Hilbert filter.

Preferably, said signals from the phase rotation are two branch signals, $I'$, $Q'$, and a DC signal is superimposed on one of the branch signals, and more preferably, said DC signal is superimposed on said branch signal $I'$ from the phase rotation.

Preferably, in said step (1), in the forward stage of said radiofrequency identification system, said reader/writer first performs single sideband modulation of the signals to be sent, shifts the frequency of said modulated signals and performs narrow-band filtering of said signals resulting from the frequency shifting, and then sends the signals resulting from the narrow-band filtering.

Accordingly, the present invention further provides a system meeting the spectral mask in a radiofrequency identification system, wherein said system includes a reader/writer and more than one tag, wherein said system further includes a gate and a signal processing device;

when said gate is turned on, said reader/writer performs single sideband modulation of the signals to be sent through said signal processing device, shifts the frequency of said modulated signals, and then sends said signals resulting from the frequency shifting; when said gate is turned off, said reader/writer sends only one carrier wave to said tags through said signal processing device.

Preferably, said signal processing device includes:

an encoder and a shaper used for said reader/writer to perform baseband coding and pulse shaping of the signals to be sent;
a delayer and a filter used for said reader/writer to delay and filter the shaped signals to generate two branch signals I, Q;
a phase rotator used for said reader/writer to perform phase rotation of said two branch signals I, Q;
a signal transmitter used for said reader/writer to convert the signals resulting from the phase rotation to analog signals and send through the RF modulation.

Preferably, said signal processing device further includes a DC generator, wherein said DC generator is connected to one output of said phase rotator, and is logically AND to the output of said phase rotator.

Preferably, said signal processing device further includes a narrow-band filter, wherein said narrow-band filter is connected to the front of said signal transmitter and is used to perform narrow-band filtering of the signals output from said signal processing device.

The method meeting the spectral mask in a radiofrequency identification system provided by the present invention has the following advantages:

first of all, the frequency shifting single sideband modulation enables the reader/writers to use the forward link of a high data transfer rate for communication, without the fear of failing to meet the requirements of the ETSI spectral masks.

secondly, since nearly all reader/writers support single sideband modulation, it is rather convenient to achieve single sideband modulation with frequency shift in the reader/writer. There are many methods which can achieve single sideband modulation with frequency shift, because it needs only slight modifications of the single sideband modulation.

Finally, the single sideband modulation with frequency shift and the tag reading performance are independent of each other, and tests have verified that the receipt of tag commands is not affected.

Description of Drawings

The particular embodiments of the present invention will be further described below in combination with the drawings, wherein:

Figure 1 shows a communication channel defined by the ETSI standard in the prior art;

Figure 2 shows old and new spectral masks defined in the ETSI standard for signals in the prior art;

Figure 3 shows pulse interval encoding symbols used by the base band of the forward link in the prior art;

Figure 4 shows a comparison between the DSB-ASK modulation signal frequency spectrum and the ETSI spectral mask in the prior art, wherein (a) Tari=25μs, x=Tari; (b) Tari=12.5μs, x=Tari; (c) Tari=6.25μs, x=Tari/2;

Figure 5 shows that in the prior art, even if Tari=6.25 μs and x=Tari, the frequency spectrum of the upper single sideband modulation signal cannot meet the needs of the ETSI spectral masks;

Figure 6 is a schematic diagram showing how single sideband signals are generated in the present invention when the frequency shift is $f_s$;

Figure 7 is a complete schematic diagram showing how signals meeting the ETSI spectral mask requirements are generated in the present invention;

Figure 8 is a schematic diagram showing the signal between the reader/writer and tag;

Figure 9 shows the frequency spectrum of single sideband modulation with a frequency shift of 100KHz;

Figure 10 shows the frequency spectrum of single sideband modulation with a frequency shift of 90KHz;

Figure 11 shows the frequency spectrums of single sideband modulation signals with a frequency shift of 90KHz when the bandwidth of the reconstruction filter is set to different values.

Exemplary Embodiments

In the prior art, the frequency spectrum of an upper single sideband modulation signal cannot meet the requirements of the ETSI spectral masks. However, when the upper single sideband modulation is used, there is still a lot of space within the low frequency range. The present invention provides a method to meet the needs of the ETSI spectral masks when transferring data in the forward link at a high data rate. In the following examples of the present invention, the upper single sideband modulation is still used to reduce the bandwidth of the modulation signal. Frequency shifting enables the spectral mask to accommodate the peaks of the modulation signal frequency spectrum. In this example, the carrier frequency can shift from $f_c$, the center of the communication channel, to a lower frequency $f_c$- $f_s$, so that the modulation signal can meet the requirements of the ETSI spectral masks, wherein $f_s$ represents the total amount of the frequency shift.

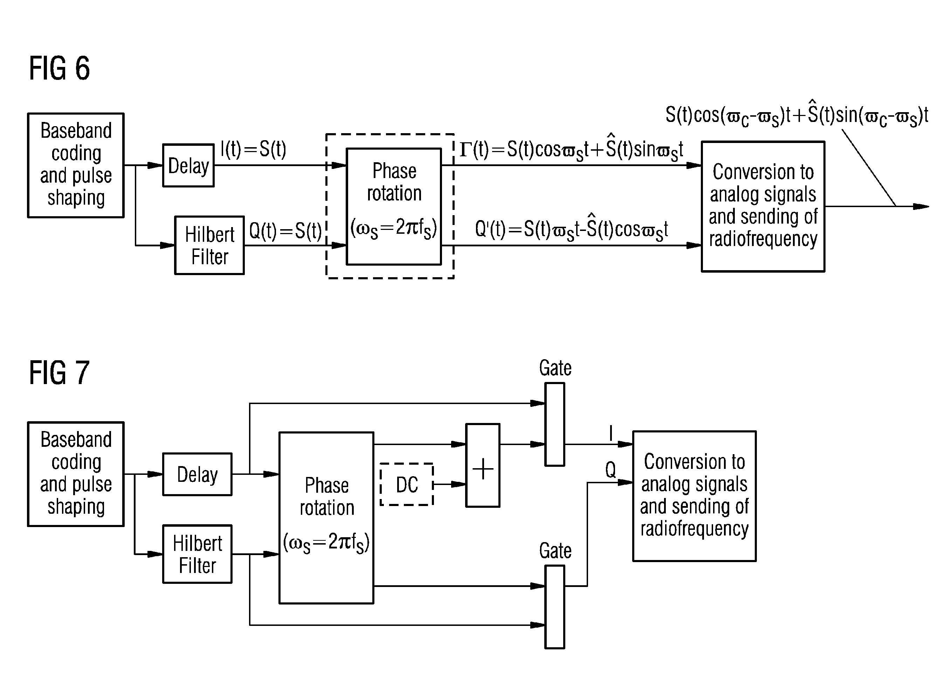

Figure 6 is a schematic diagram showing how single sideband signals are generated in the present invention when the frequency shift is $f_s$ . Firstly, baseband coding and pulse shaping are performed on signal $S(t)$ to be sent, then signal S(t) is divided into two parts, one of which becomes branch signal I after a delay, i.e. $I(t)=S(t)$, while the other becomes branch signal Q after passing through the Hilbert filter, i.e. $Q(t)=\hat{S}(t)$. Since the Hilbert filter will cause the signal to have a 90˚ phase shift, branch signal Q will have a 90˚ phase shift compared to branch signal I.

Next, phase rotation is performed on both of said branch signals I and Q to obtain the resulting signals $I'$ and $Q'$ from the phase rotation. In which case,

$$I'(t) = S(t)\cos\varpi_s t + \hat{S}(t)\sin\varpi_s t \qquad (1)$$

$$Q'(t) = S(t)\sin\varpi_s t - \hat{S}(t)\cos\varpi_s t \qquad (2)$$

Said phase rotation can be achieved in many ways. For example, phase rotation can be achieved using a CORDIC algorithm in the digital base band.

Next, the signals from the phase rotation are converted to analog signals and sent via the RF modulation, wherein signals $I'(t)$ with the same phase are multiplied by $cos(2\pi f_s t)$, while signals $Q'(t)$ with a 90˚ phase shift are multiplied by $sin (2\pi f_s t)$.

The output of the radiofrequency part is:

$$S_{ssb}(t) = s(t) \cdot \cos(2\pi(f_c - f_s) \cdot t) - \hat{s}(t) \cdot \sin(2\pi(f_c - f_s) \cdot t) \qquad (3)$$

In which case, the carrier frequency is $f_c$-$f_s$.

Figure 7 is a complete schematic diagram showing how signals meeting the ETSI spectral mask requirements are generated in the present invention. Compared to Figure 6, Figure 7 has a gate added. In the forward stage of said radiofrequency identification system, i.e. in the stage when signals are sent from the reader/writer to tags, the gate is turned on. At this time, the reader/writer performs single sideband modulation of the signals to be sent, shifts the frequency of said modulated signals, and sends the signals resulting from the frequency shifting. See above for Figure 6 for the specific process.

In the reverse stage of the radiofrequency identification system, when said gate is turned off, said reader/writer removes said frequency shift and sends a carrier wave to said tags only through the signal processing device. At this time, the reader/writer sends a high level signal in branches I and Q. However, the high level signal is different from the signals with data sent from the reader/writer in the forward link, and is only intended to generate a carrier wave, for example, both I and Q branches send a full "1" baseband signal.

In addition, as the gate is turned off in the reverse stage, no phase rotation is performed following the two high level branch signals. Since no phase rotation is performed, the final signals sent have no frequency shift, and the final carrier wave obtained from the reverse link is located in the center of the spectral mask.

The effects of the method of using the forward frequency shift and using the reverse frequency shift only for sending carrier wave to meet the spectral mask requirements can be verified with a spectrometer. As frequency shifting has been performed on the signals in the forward link of the radiofrequency identification system, so the central frequency of the signals in the forward link reflected on the spectrometer does not overlap the center of the spectral mask; in the reverse link, since only a carrier wave is sent, the central frequency of the carrier wave in the reverse link overlaps the center of the spectral mask. To ensure that, from the observer's angle, the central frequency both in the forward link and in the reverse link overlaps the center of the spectral mask, a DC signal is added in the forward link. As shown in Figure 7, the DC signal is added to an output branch of the phase rotator, often branch $I'(t)$. DC signal A is logically AND to the output $I'(t)$ of the phase rotator to obtain

$$I_1'(t) = I'(t) + A \qquad\qquad (4)$$

Then the signals from the phase rotation are converted to analog signals and sent through the RF modulation, wherein signal $I'_1(t)$, the AND result of DC signal A and signal $I'(t)$ of the same phase, is multiplied by $cos(2\pi f_s t)$, while signal $Q'(t)$ with a 90° phase shift is multiplied by $sin(2\pi f_s t)$.

After the above processing, the central frequency of the signals both in the forward link and in the reverse link reflected on the spectrometer overlaps the center of the spectral mask.

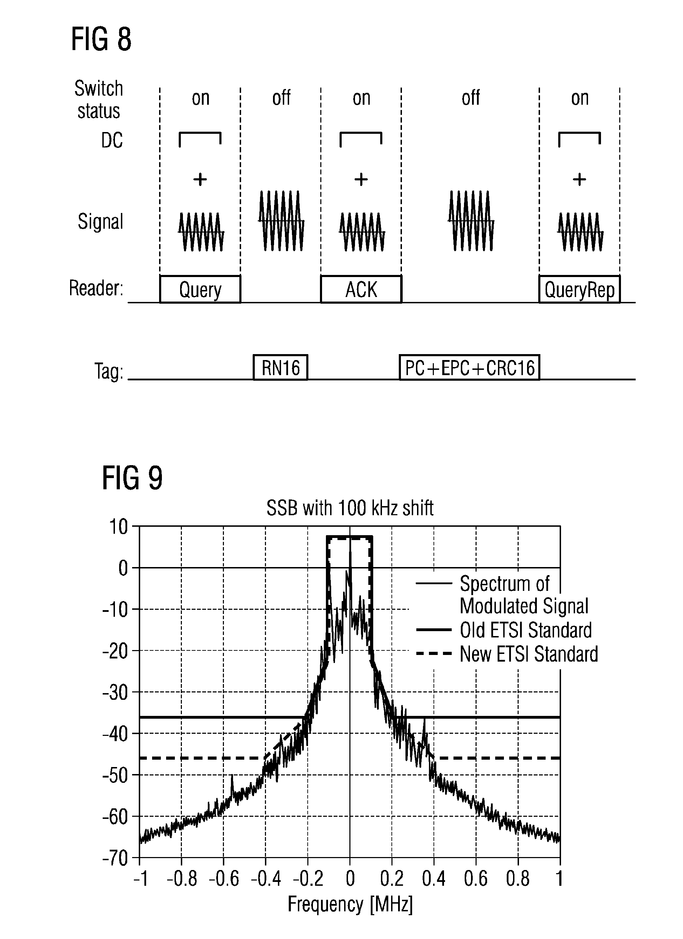

Figure 8 shows a schematic diagram of signals between the reader/writer and tag. In Figure 8, "on" means the gate is turned on, "off" means the gate is turned off, and "DC" means a DC signal is added to the output branch $I'(t)$ of the phase rotator in the forward link. "Reader" is the reader/writer, and "Tag" is the tags. In this case, in the forward link, the reader/writer sends the query command "Query", confirming command "ACK" and re-query command "QueryRep" to the tags, while in the reverse link, the tags send the Handle RN16 core data packet PC+EPC+CRC16 to the reader/writer.

See also Figure 6 and Figure 7 for the system meeting the spectral mask in a radiofrequency identification system provided by the present invention. In this case, the radiofrequency identification system includes a reader/writer and at least one tag, and the system of the present invention further includes a gate and a signal processing device.

When the gate is turned on, the reader/writer performs single sideband modulation of the signals to be sent through said signal processing device and shifts the frequency of the modulated signals, and then sends the signals resulting from the frequency shifting; when the gate is turned off, said reader/writer sends one carrier wave to said tags only through said signal processing device.

The signal processing device comprises: an encoder and a shaper, which are respectively used by said reader/writer to perform the baseband coding and pulse shaping on the signals to be sent; a delayer and a filter, which are used by said reader/writer respectively to delay and filter the shaped signals so as to generate two branch signals I, Q; a phase rotator, which is used by said reader/writer to perform phase rotation on said two branch signals I, Q; a signal transmitter, which is used by said reader/writer to convert the resulting signals from the phase rotation to analog signals and send through the RF modulation.

The signal processing device further includes a DC generator, wherein said DC generator is connected to one output of said phase rotator, and is logically AND to the output of said phase rotator.

Furthermore, the signal processing device also includes a narrow-band filter which is connected to the front of said signal transmitter and is used to perform narrow-band filtering of the signals output from said signal processing device.

To verify the result of the present invention, Figures 9 through 11 simulate the method of the present invention. This is because, in the present invention, the amount of frequency shift mainly depends on the bandwidth of the modulation signals. In order to have more redundancy for the frequency spectrum of upper single sideband modulation, it is desirable to have as much frequency shift as possible. However, the amount of frequency shift should be less than 100KHz, as the frequency spectrum of the modulated signals may exceed the ETSI spectral mask on the other side. When the frequency shift is 100KHz, the frequency spectrum of the upper single sideband modulation signal is used, as shown in Figure 9. Although the top of the mixed frequency spectrum is within the ETSI spectral mask, the frequency spectrum of the modulation signals still exceeds the lower limit of the ETSI spectral mask, and the mixed frequency spectrum in the first adjacent communication channel is still outside the old ETSI spectral mask, let alone the new ETSI spectral mask.

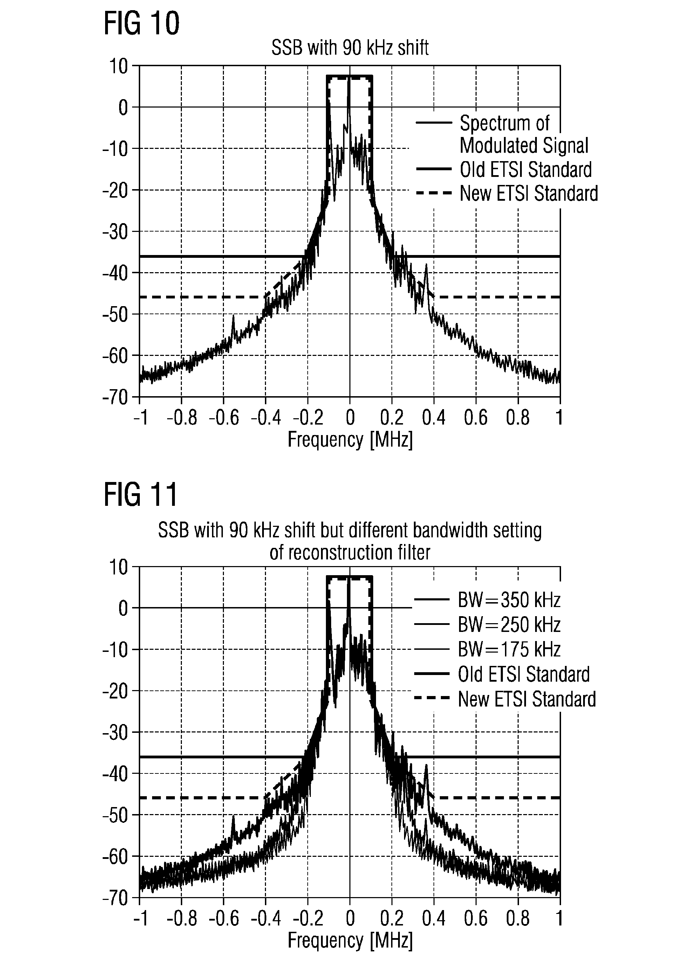

Figure 10 shows the frequency spectrum of single sideband modulation signals with a frequency shift of 90KHz. As shown, the signal frequency spectrum can mainly meet the requirements of the ETSI spectral mask except that some jitters outside the communication channel are located out of the ETSI spectral mask.

In order to shield more stray RF radiation outside the communication channel and to meet the requirements of the ETSI spectral mask, a narrow-bandwidth reconstruction filter should be used to smoothen the analog signals after the digital-to-analog conversion. As shown in Figure 11, the narrow-bandwidth reconstruction filter can reduce more radio radiation outside the communication channel. When the bandwidth of the reconstruction filter is set to 175KHz, the radio radiation outside the communication channel is significantly suppressed after passing through the reconstruction filter (see the innermost signal frequency spectrum shown in Figure 11). When the frequency shift is 90KHz, there are no out-of-mask jitters in the frequency spectrum of the single sideband modulation signals.

The above only describes the preferred embodiments of the present invention. It should be noted that those of ordinary skill in the art can make some improvements and refinements without departing from the principles of the present invention, and such improvements and refinements should be deemed covered by the protective scope of the present invention.

**Claims**

1. A method meeting the spectral mask in a radiofrequency identification system, wherein said frequency identification system includes a reader/writer and a set of tags, **characterized in that:** the method includes the following steps:

   (1) in the forward stage of said radiofrequency identification system, said reader/writer first performs single sideband modulation of the signals to be sent, shifts the frequency of said modulated signals, and then sends said signals resulting from the frequency shifting;
   (2) in the reverse stage of said radiofrequency identification system, said reader/writer sends only one carrier wave to said tags.

2. The method meeting the spectral mask in a radiofrequency identification system as claimed in claim 1, **characterized in that:** in said step (2), in the reverse stage of said radiofrequency identification system, said reader/writer removes said frequency shift and sends one carrier wave to said tags at the original carrier frequency only.

3. The method meeting the spectral mask in a radiofrequency identification system as claimed in claim 1 or 2, **characterized in that:** in said step (1), said reader/writer first performs single sideband modulation of the signals to be sent, shifts the frequency of said modulated signals, and then sends said signals resulting from the frequency shift, wherein said step further includes:

   said reader/writer performs baseband coding and pulse shaping of the signals to be sent;
   said reader/writer delays and filters the shaped signals to generate two branch signals I, Q;
   said reader/writer performs phase rotation of said two branch signals I, Q;
   said reader/writer converts the signals resulting from the phase rotation to analog signals and sends through the RF modulation.

4. The method meeting the spectral mask in a radiofrequency identification system as claimed in claim 3, **characterized in that:** said filter is a Hilbert filter.

5. The method meeting the spectral mask in a radiofrequency identification system as claimed in claim 3, **characterized in that:** said signals from the phase rotation are two branch signals, $I'$ and $Q'$, and a DC signal is superimposed on one of the branch signals.

6. The method meeting the spectral mask in a radiofrequency identification system as claimed in claim 5, **characterized in that**: said DC signal is superimposed on said branch signal $I'$ from the phase rotation.

7. The method meeting the spectral mask in a radiofrequency identification system as claimed in claim 1, **characterized in that:** in said step (1), in the forward stage of said radiofrequency identification system, said reader/writer first performs single sideband modulation of the signals to be sent, shifts the frequency of said modulated signals and performs narrow-band filtering of said signals resulting from the frequency shifting, and then sends the signals resulting from the narrow-band filtering.

8. A system meeting the spectral mask in a radiofrequency identification system, wherein said system includes a reader/writer and more than one tag, **characterized in that:**

   said system further includes a gate and a signal processing device;

when said gate is turned on, said reader/writer performs single sideband modulation of the signals to be sent through said signal processing device, shifts the frequency of said modulated signals, and then sends said signals resulting from the frequency shifting; when said gate is turned off, said reader/writer sends only one carrier wave to said tags through said signal processing device.

9. The system meeting the spectral mask in a radiofrequency identification system as claimed in claim 8, **characterized in that:** said signal processing device includes:

an encoder and a shaper used for said reader/writer to perform baseband coding and pulse shaping of the signals to be sent;
a delayer and a filter used for said reader/writer to delay and filter the shaped signals to generate two branch signals I, Q;
a phase rotator used for said reader/writer to perform phase rotation of said two branch signals I, Q;
a signal transmitter used for said reader/writer to convert the signals resulting from the phase rotation to analog signals and send through the RF modulation.

10. The system meeting the spectral mask in a radiofrequency identification system as claimed in claim 9, **characterized in that:** said signal processing device further includes a DC generator, wherein said DC generator is connected to one output of said phase rotator, and is logically AND to the output of said phase rotator.

11. The system meeting the spectral mask in a radiofrequency identification system as claimed in any one of claims 8 through 10, **characterized in that:** said signal processing device further includes a narrow-band filter, wherein said narrow-band filter is connected to the front of said signal transmitter and is used to perform narrow-band filtering of said signals output from said signal processing device.

EP 2 299 642 A2

FIG 1

865.0 MHz                                    Frequency                                    868.0 MHz

865.2 865.4 865.6 865.8 866.0 866.2 866.4 866.6 866.8 867.0 867.2 867.4 867.6 867.8

1    2    3    4    5    6    7    8    9    10   11   12   13   14   15

FIG 2

Spectrum Mask for Signals in ETSI Standard

Old ETSI Standard
New ETSI Standard

FIG 3

1.5 Tari ≤ data-1 ≤ 2.0 Tari

Tari

0.5 Tari ≤ x ≤ Tari

PW

PW

data-0

data-1

# FIG 4

**(a)**

Spectrum of Modulated Signal
Old ETSI Standard
New ETSI Standard

Frequency [MHz]

**(b)**

Spectrum of Modulated Signal
Old ETSI Standard
New ETSI Standard

Frequency [MHz]

**(c)**

Spectrum of Modulated Signal
Old ETSI Standard
New ETSI Standard

Frequency [MHz]

## FIG 5

SSB without frequency shift

Legend:
— Spectrum of Modulated Signal
— Old ETSI Standard
- - - New ETSI Standard

X-axis: Frequency [MHz]

## FIG 6

Baseband coding and pulse shaping

Delay — $I(t)=S(t)$

Hilbert Filter — $Q(t)=S(t)$

Phase rotation $(\omega_S=2\pi f_S)$

$\Gamma(t)=S(t)\cos\varpi_S t+\hat{S}(t)\sin\varpi_S t$

$Q'(t)=S(t)\varpi_S t-\hat{S}(t)\cos\varpi_S t$

Conversion to analog signals and sending of radiofrequency

$S(t)\cos(\varpi_C-\varpi_S)t+\hat{S}(t)\sin(\varpi_C-\varpi_S)t$

## FIG 7

Baseband coding and pulse shaping

Delay

Hilbert Filter

Phase rotation $(\omega_S=2\pi f_S)$

DC

$+$

Gate

Gate

I

Q

Conversion to analog signals and sending of radiofrequency

EP 2 299 642 A2

## FIG 8

| Switch status | on | off | on | off | on |
| --- | --- | --- | --- | --- | --- |

DC, Signal timing diagram

Reader: Query — ACK — QueryRep

Tag: RN16 — PC+EPC+CRC16

## FIG 9

SSB with 100 kHz shift

— Spectrum of Modulated Signal
— Old ETSI Standard
- - - New ETSI Standard

Frequency [MHz]

# FIG 10

**SSB with 90 kHz shift**

Legend:
- Spectrum of Modulated Signal
- Old ETSI Standard
- - - New ETSI Standard

Y-axis: 10, 0, -10, -20, -30, -40, -50, -60, -70
X-axis: Frequency [MHz] — -1, -0.8, -0.6, -0.4, -0.2, 0, 0.2, 0.4, 0.6, 0.8, 1

# FIG 11

**SSB with 90 kHz shift but different bandwidth setting of reconstruction filter**

Legend:
- BW = 350 kHz
- BW = 250 kHz
- BW = 175 kHz
- Old ETSI Standard
- - - New ETSI Standard

Y-axis: 10, 0, -10, -20, -30, -40, -50, -60, -70
X-axis: Frequency [MHz] — -1, -0.8, -0.6, -0.4, -0.2, 0, 0.2, 0.4, 0.6, 0.8, 1